# EUROPÄISCHE PATENTANMELDUNG

(11) **EP 2 408 012 A2**
(43) Veröffentlichungstag der Anmeldung: **18.01.2012**
(21) Anmeldenummer: 11170230.4
(22) Anmeldetag: 16.06.2011
(51) Int. Cl.: H01L 31/0216

(54) **Solarzelle, Solarzellenherstellungsverfahren und Prüfverfahren**

(30) Priorität: 18.06.2010 DE 102010017461
(71) Anmelder: Q-Cells SE, 06766 Bitterfeld-Wolfen (DE)
(72) Erfinder: Kux, Andreas, 85540 Haar (DE); Junghänel, Matthias, 04229 Leipzig (DE); Schädel, Martin, 06114 Halle (DE); Scherff, Maximilian, 44369 Dortmund (DE)
(74) Vertreter: Bakhtyari, Arash

(57) **Zusammenfassung**

Die Erfindung betrifft eine Solarzelle, ein Solarzellenherstellungsverfahren und ein Prüfverfahren. Die erfindungsgemäße Solarzelle (1) umfasst einen Halbleitersubstrat (10) und eine lichteinfallseitig auf der Vorderseitenoberfläche (11) des Halbleitersubstrats (10) angeordnete Antireflexionsschicht (2), welche entlang einer Schichtdicke der Antireflexionsschicht (2) eine Grenzspannung von weniger als 10, weniger als 5 oder weniger als 3 Volt aufweist.

## Beschreibung

Die Erfindung betrifft eine Solarzelle, ein Solarzellenherstellungsverfahren und ein Prüfverfahren.

Die gegenwärtig effizientesten Solarmodule werden aus einzelnen Solarzellen zusammengesetzt, welche mittels sogenannter Zellverbinder zu Strings zusammengeschaltet werden. Diese Strings werden zum Schutz gegen Umwelteinflüsse mit einer Kunststofffolie überzogen und durch eine Glasplatte bedeckt in einen Rahmen eingebaut. Das Solarmodul wird außerdem entlang der Solarzellenrückseiten mittels einer Rückseitenfolie verkapselt. Einfallendes Licht tritt also zunächst durch die Glasplatte, anschließend durch die Kunststofffolie und trifft dann auf die Vorderseite einer Solarzelle. Die Kunststofffolie ist üblicherweise aus Ethylen-Vinyl-Acetat (EVA) gebildet. Außerdem sind die Solarzellen zur Verminderung der Rückreflexion des einfallenden Lichts in der Regel mit einer Antireflexionsschicht beschichtet, so dass die Schichtoberfläche der Antireflexionsschicht an der Kunststofffolie anliegt.

Beim Betrieb des Solarmoduls in einem String aus einem oder mehreren Solarmodulen entsteht ein Potential zwischen den Solarzellen und dem Rahmen. Bei einer Reihenverschaltung der Solarzellen in dem Solarmodul steigt entlang der Reihe das elektrische Potential zwischen den Solarzellen und dem Rahmen. Eine industriell geläufige Grenze für dieses Potential liegt bei etwa 1000 Volt, die entlang einer Reihenverschaltung anliegen dürfen und für welche die Rückseitenfolie in der Regel auch ausgelegt ist. Wenn hierbei eine Solarzelle gegenüber dem Rahmen ein negatives oder positives Potential aufweist, können dementsprechend positive Ionen, beispielsweise Natrium-, Kalzium- oder Magnesiumionen, oder negative Ionen, beispielsweise Hydroxidionen (OH⁻), innerhalb der Glasplatte und aus der Glasplatte heraus und innerhalb der Kunststofffolie entlang des vorliegenden elektrischen Feldes in Richtung zur Solarzelle hin wandern. Dies bewirkt eine Ladungsträgerakkumulation an der Grenzfläche zwischen Glasplatte und Kunststofffolie und / oder an der Grenzfläche zwischen Kunststofffolie und Antireflexionsschicht, was zu einer Störung der Solarzellenfunktion führen kann. Unter Anderem kann hierdurch der Parallelwiderstand vermindert werden, was wiederum einen teilweisen oder sogar vollständigen Ausfall der betroffenen Solarzelle bewirken kann. Diese auf einer induzierten Potentialdifferenz zwischen Modulrahmen und Solarzelle beruhende Degradationswirkung wird als potentialinduzierte Degradation (PiD) bezeichnet.

Ein mögliches Vorgehen, um die Solarzellen vor einem solchen Ausfall zu schützen, besteht in der Vermeidung von negativen Potentialdifferenzen (bei vorderseitigen n-typ Emitter) und positiven Potentialdifferenzen (bei vorderseitigen p-typ Emitter) zwischen dem Rahmen des Solarmoduls und den darin enthaltenen Solarzellen. Die hierfür notwendigen Maßnahmen zur Erdung können jedoch unter Umständen sehr aufwendig sein. Zudem wird dadurch die Auswahl der Stromwechselrichter eingeschränkt und der Systemwirkungsgrad kann negativ beeinflusst werden. Weiterhin ist der Einsatz von Glasplatten aus Borosilikat-Glas möglich, weil darin weniger ionische Bestandteile enthalten sind, die zur Ansammlung von Ladungen beitragen können. Die hierdurch bedingte Kostensteigerung für die Solarmodule wäre jedoch wirtschaftlich nicht tragbar. Schließlich kann versucht werden, die Kunststofffolie aus einem geeigneteren Material als EVA herzustellen, beispielsweise aus Silikone (zum Beispiel Tectosil der Firma Wacker), PVB (Poly-Vinyl-Butyral) oder Thermoplastik (zum Beispiel Surlyn der Firma Dupont), da bei EVA negative Einflüsse durch die enthaltene Essigsäure und hohe Wasser- und Feuchtigkeitsdurchlässigkeit vermutet werden. Es zeigt sich jedoch, dass EVA-Folien aus verschiedenen Gründen sehr Vorteilhaft für den Einsatz in Solarmodulen sind.

Es ist daher Aufgabe der Erfindung, die Gefahr einer potentialinduzierten Degradation bei Solarzellen auf effektive und kostengünstige Weise zu vermindern oder gar im Wesentlichen vollständig auszuschließen.

Die Aufgabe wird gemäß der Erfindung durch eine Solarzelle mit den Merkmalen des Anspruchs 1, ein Solarzellenherstellungsverfahren mit den Merkmalen des Anspruchs 9 und ein Prüfverfahren mit den Merkmalen des Anspruchs 10 gelöst. Vorteilhafte Weiterbildungen der Erfindung sind in den Unteransprüchen aufgeführt.

Die Erfindung beruht auf den Gedanken, dass bei der im Solarmodul eingebauten Solarzelle die Akkumulation von Ladungen an den Grenzflächen Glasplatte/Kunststofffolie und / oder Kunststofffolie/Antireflexionsschicht für die potentialinduzierte Degradation verantwortlich ist. Deshalb ist die der Erfindung zugrunde liegende Überlegung, dass die Solarzelle derart ausgebildet sein muss, dass diese Ladungen durch die Antireflexionsschicht, also entlang der Schichtdicke der Antireflexionsschicht oder quer zu einer Schichtoberfläche der Antireflexionsschicht, zum Halbleitersubstrat abfließen oder neutralisiert werden. Die Grenzspannung kann als die Spannung angesehen werden, ab der sich ein Gleichgewicht des zur Grenzfläche Kunststofffolie/Antireflexionsschicht fließenden Stromes und dem durch oder entlang der Antireflexionsschicht abfließenden Stromes einstellt. Erst dann ist eine weitere Akkumulation von Ladungen an der Grenzfläche nicht mehr möglich.

Die Erfinder haben herausgefunden, dass die potentialinduzierte Degradation in dem fertig zusammengebauten Solarmodul immer dann wirksam verhindert wird, wenn die Antireflexionsschicht jeder einzelnen Solarzellen selbst eine Grenzspannung aufweist, welche unterhalb eines bestimmten Wertes liegt. Für die Messung der Grenzspannung der Antireflexionsschicht wird bei der unkontaktierten Solarzelle, also während der Solarzellenherstellung nach dem Abscheiden der Antireflexionsschicht aber vor dem Metallisieren, auf der Antireflexionsschicht eine Koronaentladung erzeugt. Hierbei dient das Halbleitersubstrat, auf dem die Antireflexionsschicht angeordnet ist, als eine Elektrode und eine Koronaentladungselektrode als eine weitere Elektrode für die Koronaentladung. Anschließend wird eine elektrische Oberflächenspannung auf der Schichtoberfläche der Antireflexionsschicht gemessen.

Diese elektrische Oberflächenspannung kann entlang der Schichtoberfläche der Antireflexionsschicht variieren und ist mittels einer kapazitiven Sonde messbar, beispielsweise mittels einer Kelvinsonde. Wenn die gemessene elektrische Oberflächenspannung niedriger ist, als eine Grenzspannung mit einem vorangehend aufgeführten Wert, kann davon ausgegangen werden, dass die Solarzelle mit dieser Antireflexionsschicht im Solarmodul auch ohne Erdung keine potentialinduzierte Degradation erfährt.

Die Koronaentladung erzeugt auf der Schichtoberfläche der Antireflexionsschicht eine Oberflächenladung, indem eine Hochspannung von einigen Kilovolt (kV) zwischen einer Rückseitenoberfläche des Halbleitersubstrates, bei dem es sich beispielsweise um einen Halbleiterwafer handeln kann, und der Koronaentladungselektrode angelegt wird. Die Koronaentladungselektrode ist hierbei in einem Abstand von einigen Zentimetern (cm) über der Schichtoberfläche der Antireflexionsschicht angeordnet. Die Messung der elektrischen Oberflächenspannung wird unmittelbar danach durchgeführt. Als ein Beispiel, kann die angelegte Hochspannung 5,2kV betragen, wobei der Abstand zwischen der Schichtoberfläche der Antireflexionsschicht und der Spitze der Koronaentladungselektrode etwa 10cm beträgt. Hierbei stellt sich ein Stromfluss in der Korona von etwa 0,2 Mikroampere (µA) ein, der nach etwa 30 Minuten keine weitere Änderung der anschließend zum Beispiel durch eine Kelvinsonde messbaren elektrischen Oberflächenspannung verursacht.

Bei der auf der Schichtoberfläche der Antireflexionsschicht gemessenen elektrischen Oberflächenspannung kann es sich vorzugsweise um die Durchbruchspannung der Antireflexionsschicht handeln. Die Grenzspannung beschreibt in diesem Fall eine maximale Durchbruchspannung, die vorliegen darf, damit die Solarzelle als nicht anfällig für potentialinduzierte Degradation einzustufen ist. Die Grenzspannung ist jedoch ein allgemeinerer Parameter als die Durchbruchspannung. Mit einer Durchbruchspannung können nur Antireflexionsschichten charakterisiert werden, welche einer Durchbruchkennlinie folgen. In diesem Fall steigt bei Überschreitung der Durchbruchspannung der Strom durch die Schicht exponentiell an. Demgegenüber kann mit der Grenzspannung auch eine Antireflexionsschicht charakterisiert werden, welche auch bei geringer Spannung eine Leitfähigkeit aufweist, dessen Leitfähigkeit aber erst mit Überschreitung der Grenzspannung ausreichend ist, um einen effektiven Ladungsabtransport zu erlauben. Mit den nachfolgend beschriebenen Behandlungen der Antireflexionsschicht zur Verringerung der Grenzspannung kann somit die Leitfähigkeit der Antireflexionsschicht erhöht und / oder seine Durchbruchspannung verringert werden.

Bei der Herstellung der hier beschriebenen Solarzelle, sollten die Herstellungsparameter derart gewählt werden, dass die Antireflexionsschicht wie erläutert eine genügend niedrige Grenzspannung aufweist. Alternativ oder zusätzlich kann auch das vorangehend beschriebene Prüfverfahren eingesetzt werden, um die Grenzspannung der Antireflexionsschicht zu prüfen und jene Solarzellen als geeignet für die Weiterverarbeitung zu Solarmodulen einzustufen, welche das obige Kriterium erfüllen. Gegenüber dem sonst üblichen Vorgehen, bei dem die Anfälligkeit für potentialinduzierte Degradation (PiD) erst nach dem Einbau der Solarzelle in das Solarmodul erkannt werden kann, hat das hier beschriebene Prüfverfahren den Vorteil, dass diese PiD-Anfälligkeit noch vor dem Einbau der Solarzelle in das Solarmodul erfolgen kann. Als PiD-anfällig eingestufte Solarzellen können dann bereits früh aussortiert werden.

Es gibt eine Reihe von Vorgehensweisen, um eine Antireflexionsschicht mit der gewünschten Grenzspannung herzustellen. Dies geschieht vorzugsweise mittels Auswahl des Materials der Antireflexionsschicht und / oder der stöchiometrischen Zusammensetzung der Stoffverbindung, aus der die Antireflexionsschicht gebildet ist.

In bestimmten Ausführungsformen ist es möglich, die Grenzspannung der Antireflexionsschicht mittels geeigneter Wahl ihres Brechungsindexwertes einzustellen, weil die Grenzspannung bei ansonsten gleichen Parametern von dem Brechungsindex abhängen kann. Andererseits ist es besonders vorteilhaft, wenn die Grenzspannung unterhalb der vorangehend beschriebenen Werte liegt, obwohl der Brechungsindex niedrig ist. Bei einer bevorzugten Ausführungsform ist nämlich vorgesehen, dass die Antireflexionsschicht einen bei der Wellenlänge 632nm bestimmten Brechungsindex niedriger als n=2,2, n=2,15, n=2,1, n=2,05, n=2,0, n=1,9, n=1,8, n=1,6 oder n=1,4 aufweist. Bei derart niedrigen Brechungsindexwerten tritt besonders häufig PiD auf. Durch Auswahl einer geeignet niedrigen Grenzspannung, kann jedoch auch hierbei das Auftreten einer PiD ausgeschlossen werden. Die optischen Eigenschaften der Antireflexionsschicht, insbesondere der Brechungsindex, können so von den elektrischen Eigenschaften, nämlich der Grenzspannung, getrennt werden. Hierdurch wird sichergestellt, dass die Antireflexionsschicht ihrer eigentlichen Funktion in der Solarzelle weiterhin nachkommen kann.

In einer vorteilhaften Weiterbildung ist vorgesehen, dass die Antireflexionsschicht dotiert ist. Eine Dotierung der Antireflexionsschicht mit geeigneten Dotanden bietet eine Möglichkeit, die Grenzspannung der Antireflexionsschicht zu vermindern, indem die Leitfähigkeit der Antireflexionsschicht erhöht wird. Gemäß einer zweckmäßigen Ausgestaltung ist vorgesehen, dass die Antireflexionsschicht mit Phosphor, Arsen, Fluor oder Bor dotiert ist. Alternativ können auch andere geeignete Stoffe oder Stoffverbindung als Dotanden verwendet werden.

Gemäß einer bevorzugten Ausführungsform ist in der Antireflexionsschicht ein transparentes leitfähiges Oxid beigemischt. Als ein solches transparentes leitfähiges Oxid eignen sich beispielsweise Indium-Zinnoxid, Aluminium-Zinkoxid, Antimon-Zinnoxid oder Fluor-Zinnoxid zur Verwendung innerhalb der Antireflexionsschicht.

In einer vorteilhaften Ausführungsform ist die Konzentration von Störstellen in der Antireflexionsschicht zur gezielten Beeinflussung der Leitfähigkeit der Antireflexionsschicht eingestellt. Mit anderen Worten, ist bei der Herstellung dieser Ausführungsform die Leitfähigkeit der Antireflexionsbeschichtung gezielt über die Konzentration von Störstellen in der Antireflexionsbeschichtung beeinflusst worden. Solche Störstellen können beispielsweise sein: eine erhöhte Anzahl nicht abgesättigter Bindungen (sogenannte dangling bonds), erzeugt durch zum Beispiel einen reduzierten Wasserstoffanteil der Schicht.

Bevorzugterweise ist vorgesehen, dass die Antireflexionsschicht entlang der Schichtdicke oder entlang einer Schichtoberfläche der Antireflexionsschicht verlaufende Leitfähigkeitskanäle aufweist. Diese können beispielsweise mittels Laserabtragung in der Antireflexionsschicht gebildet werden. Die Leitfähigkeitskanäle können mit einem leitfähigkeitssteigernden Material gefüllt sein. Alternativ können die Leitfähigkeitskanäle leer bleiben, wobei die Leitfähigkeitssteigerung aufgrund Oberflächenleitung entlang von Innenoberflächen der Leitfähigkeitskanäle erfolgt.

Bei Leitfähigkeitskanälen entlang der Schichtoberfläche der Antireflexionsschicht handelt es sich vorzugsweise um flache Gräben oder flächige Deckschichten, welche in der Schichtoberfläche gebildet sind. Demgegenüber sind die entlang der Schichtdicke verlaufende Leitfähigkeitskanäle vorzugsweise Löcher in der Antireflexionsschicht. Bei einer zweckmäßigen Ausführungsform ist vorgesehen, dass sich die Leitfähigkeitskanäle in der Antireflexionsschicht durch die gesamte Schichtdicke der Antireflexionsschicht erstrecken. Hierbei handelt es sich also um Durchgangslöcher durch die Antireflexionsschicht, welche bis zu dem darunterliegenden Halbleitersubstrat reichen.

In einer vorteilhaften Ausgestaltung ist vorgesehen, dass die Antireflexionsschicht aus Siliziumcarbid, Siliziumoxid, Siliziumnitrid, Siliziumoxinitrid, Aluminiumoxid, Metalloxid oder einer Kombination hieraus gebildet ist. Die Antireflexionsschicht kann auch aus mehreren Teilschichten aufgebaut sein. In diesem Fall können die einzelnen Teilschichten jeweils aus einem anderen Material gebildet sein, vorzugsweise umfassend eine der oben aufgeführten Siliziumverbindungen.

Gemäß einer bevorzugten Weiterbildung ist vorgesehen, dass auf der Antireflexionsschicht Kontaktelektroden angeordnet sind. Bei dieser Ausführungsform handelt es sich also um eine beidseitig kontaktierte Solarzelle, bei der sowohl vorderseitig als auch rückseitig eine Kontaktierung vorliegt. Vorzugsweise können jedoch alle hierin beschriebenen Ausführungsformen auch in Zusammenhang mit ausschließlich rückseitenkontaktierten Solarzellen eingesetzt werden, bei denen also die Kontaktelektroden für beide Polarisationen auf der Solarzellenrückseite angeordnet sind.

Die Erfindung wird im Folgenden anhand von Ausführungsbeispielen unter Bezugnahme auf die Figuren erläutert. Hierbei zeigen:
Fig. 1a-1e schematische Querschnittansichten von Zwischenschritten bei der Herstellung einer Solarzelle gemäß einer bevorzugten Ausführungsform;
Fig. 2 eine Solarzelle mit einer dotierten Antireflexionsschicht;
Fig. 3 eine Solarzelle mit einer mit Leitfähigkeitskanälen versehenen Antireflexionsschicht;
Fig. 4 schematisch einen Messaufbau zur Prüfung der Anfälligkeit einer Solarzelle für potentialinduzierte Degradation; und
Fig. 5 einen schematischen Querschnitt durch eine in ein Solarmodul eingebaute Solarzelle.

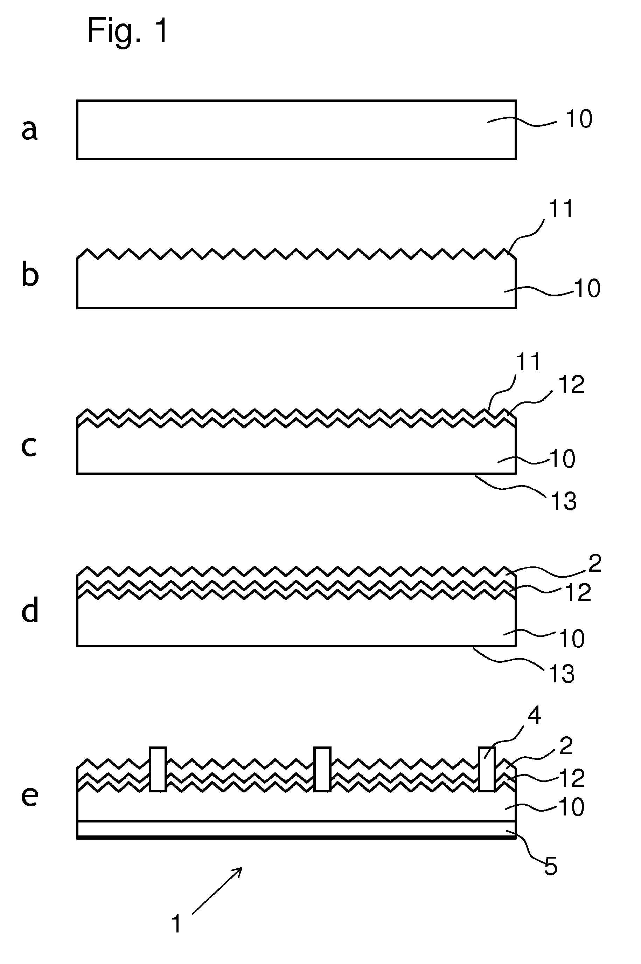

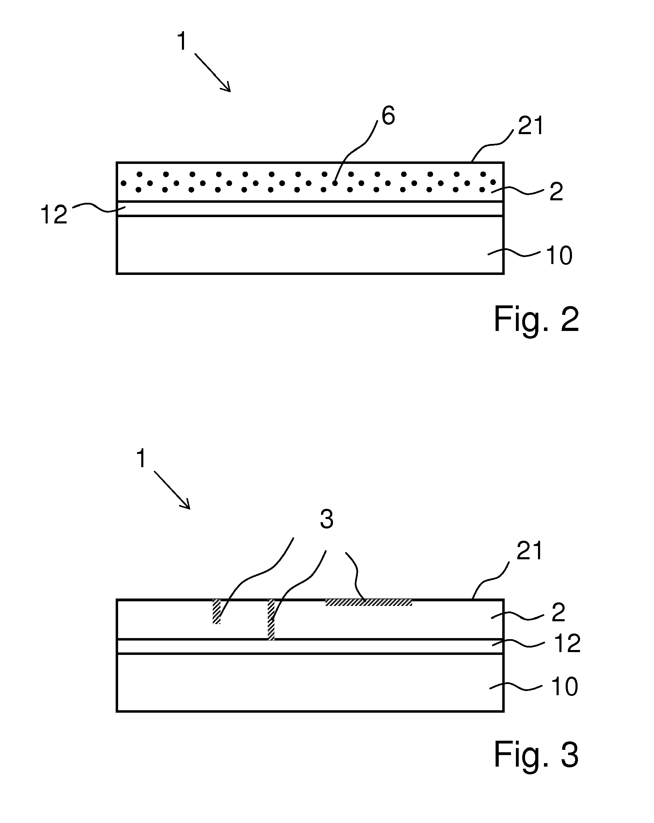

Die Fig. 1a bis 1e veranschaulichen ein Solarzellenherstellungsverfahren. Hierbei wird zunächst gemäß Fig. 1a ein Halbleitersubstrat 10 bereitgestellt, vorzugsweise in Form eines Silizium-Wafers. Nach eventuellen Reinigungsschritten, wird das Halbleitersubstrat 10 einem Oberflächentexturverfahren unterzogen, um eine Vorderseitenoberfläche 11 zu Texturieren. Die sich hieraus ergebende Oberflächentextur ist in der Fig. 1b schematisch dargestellt und dient dazu, den Absorptionsweg des einfallenden Lichts im Halbleiterkristall zu verlängern. Wenngleich die Textur in den Fig. 2 und 3 in Zusammenhang mit nachfolgend erläuterten Ausführungsformen der Solarzelle nicht schematisch dargestellt ist, kann sie auch dort vorzugsweise vorliegen.

Wie in der Fig. 1c dargestellt, wird nach dem Texturschritt in dem Halbleitersubstrat 10 mittels Dotierung eine Emitterdotierschicht 12 auf der Vorderseitenoberfläche 11 gebildet, um einen pn-Übergang zu bilden. Anschließend wird eine Antireflexionsschicht 2 auf die Emitterdotierschicht 12 aufgebracht, um die in Fig. 1d dargestellte Struktur zu erhalten. Schließlich wird die Solarzelle 1 beidseitig metallisiert, wobei auf der Vorderseitenoberfläche 11 Kontaktelektroden 4 aufgebracht werden, welche durch die Antireflexionsschicht 2 dringen und mit der Emitterdotierschicht 12 elektrisch verbunden sind. Auf der Rückseitenoberfläche 13 wird hingegen eine vollflächige Rückseitenmetallisierung 5 aufgebracht, vorzugsweise mittels Auftragen einer Metallpaste und einer anschließenden Wärmebehandlung. Wenngleich die Solarzelle 1 in der in Fig. 1e dargestellten Ausführungsform beidseitig kontaktiert ist, können alle vorliegend und nachfolgend erläuterten Merkmale betreffend die Antireflexionsschicht 2 auch auf ausschließlich rückseitenkontaktierte Solarzellen 1 übertragen werden.

Die bei dem Herstellungsverfahren gemäß Fig. 1a bis 1e auf der Solarzelle erzeugte Antireflexionsschicht 2 weist eine Grenzspannung von weniger als 10 Volt, weniger als 5 Volt oder weniger als 3 Volt auf. Zwei Beispiele, wie dies bewerkstelligt wird, sind in den Fig. 2 und 3 dargestellt.

Die Solarzelle gemäß Fig. 2 hat eine Antireflexionsschicht 2, welche dotiert ist. Die hierdurch entstehenden Dotierzentren 6 sind in der Fig. 2 schematisch als Punkte eingezeichnet. Durch geeignete Wahl des Dotanden, kann die Leitfähigkeit der Antireflexionsschicht 2 senkrecht zu ihrer Schichtoberfläche 21 erhöht werden, um die Grenzspannung auf einen gewünschten Wert zu senken.

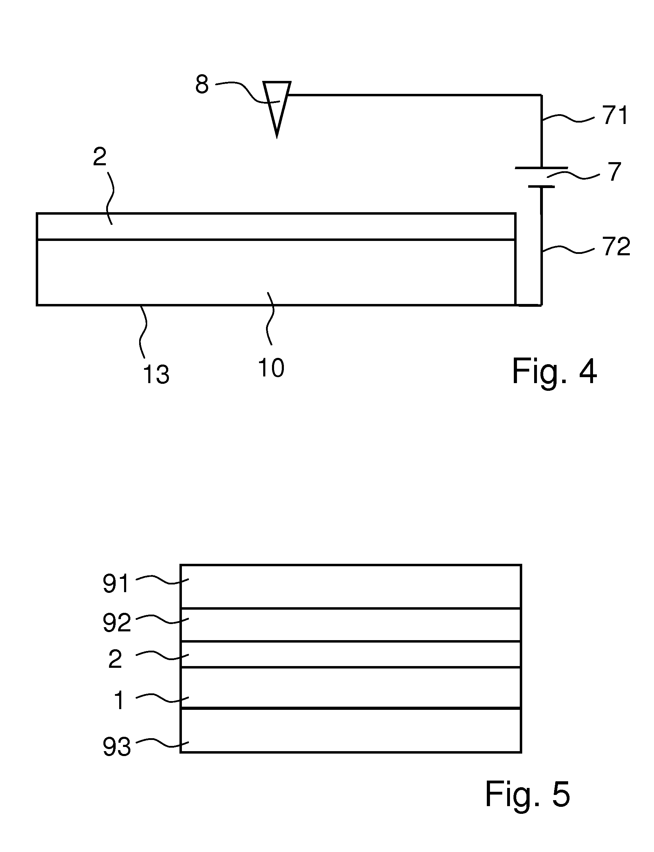

Das Prüfverfahren zur Prüfung einer Solarzelle 1 auf ihre Anfälligkeit für potentialinduzierte Degradation in einem Solarmodul, kann mittels der in Fig. 4 dargestellten Anordnung durchgeführt werden. Die Anordnung umfasst eine Hochspannungsquelle 7, dessen positiver Spannungspol 71 mit einer Koronaentladungselektrode 8 verbunden ist, und dessen negativer Spannungspol 72 mit der Rückseitenoberfläche 13 des Halbleitersubstrates 10 verbunden ist. Beispielsweise kann das Halbleitersubstrat 10 auf einer Metallplatte aufliegen, welche mit dem negativen Spannungspol 72 kontaktiert ist.

Die Koronaentladungselektrode 8 ist in einem Abstand von einigen Zentimetern über der Vorderseitenoberfläche 11 des Halbleitersubstrats 10 angeordnet. Durch Anlegen einer Hochspannung zwischen Koronaentladungselektrode 8 und Solarzelle 1 wird auf der Schichtoberfläche 21 der Antireflexionsschicht 2 eine Korona erzeugt, mit einem sehr geringen Strom im Mikroamperebereich. Nun kann nach einer gewissen Zeit, beispielsweise nach einigen wenigen oder etwa 30 Minuten, die elektrische Oberflächenspannung auf der Schichtoberfläche 21 der Antireflexionsschicht 2 gemessen werden. Dies erfolgt vorzugsweise mittels einer Kelvinsonde, welche jedoch in der Fig. 4 nicht dargestellt ist. Die Kelvinsonde wird hierzu in Schwingung versetzt und nahe an die Schichtoberfläche 21 geführt.

In der Fig. 5 ist schematisch ein Querschnitt durch eine Solarzelle dargestellt, welche in einem Solarmodul eingebaut ist. Hiermit soll lediglich die Anordnung der unterschiedlichen, für die potentialinduzierte Degradation relevanten Schichten zueinander veranschaulicht werden. Deshalb ist beispielsweise die Rückseitenmetallisierung der Solarzelle 1 nicht als separate Schicht eingezeichnet. Die Solarzelle 1 mit der Antireflexionsschicht 2 ist in dem Solarmodul vorderseitig durch eine Kunststofffolie 92 und eine Glasplatte 91 und rückseitig durch eine Rückseitenverkapselung 93 von Umwelteinflüssen geschützt. Bei der Rückseitenverkapselung 93 handelt es sich vorzugsweise um eine Rückseitenfolie.

Wenn bei einem herkömmlichen Solarmodul als Beispiel mit einem positiven vorderseitigen Emitter die Solarzelle 1 gegenüber dem Rahmen des Solarmoduls ein negatives Potential hat, wandern positive Ionen, die sich in der Glasplatte 91 befinden, durch die Glasplatte 91 und gegebenenfalls durch die Kunststofffolie 92 und können sich an den Grenzflächen zwischen der Glasplatte 91 und der Kunststofffolie 92 und / oder zwischen der Kunststofffolie 92 und dem Halbleitersubstrat 10 der Solarzelle 1 ansammeln. Indem die Antireflexionsschicht 2 wie vorangehend beschrieben ausgebildet ist, wird sichergestellt, dass vor der Akkumulation einer größeren Ladungsmenge an den genannten Grenzflächen, die Ladung durch die Antireflexionsschicht 2 in das Halbleitersubstrat 10 der Solarzelle 1 abfließen kann.

### Bezugszeichenliste:

- 1: Solarzelle
- 10: Halbleitersubstrat
- 11: Vorderseitenoberfläche des Halbleitersubstrats
- 12: Emitterdotierschicht
- 13: Rückseitenoberfläche
- 2: Antireflexionsschicht
- 21: Schichtoberfläche der Antireflexionsschicht
- 3: Leitfähigkeitskanäle
- 4: Kontaktelektroden
- 5: Rückseitenmetallisierung
- 6: Dotierzentren
- 7: Hochspannungsquelle
- 71: positiver Spannungspol
- 72: negativer Spannungspol
- 8: Koronaentladungselektrode
- 91: Glasplatte
- 92: Kunststofffolie
- 93: Rückseitenverkapselung

## Patentansprüche

1. Solarzelle (1) mit einem Halbleitersubstrat (10) und einer lichteinfallseitig auf der Vorderseitenoberfläche (11) des Halbleitersubstrats (10) angeordneten Antireflexionsschicht (2), welche entlang einer Schichtdicke der Antireflexionsschicht (2) eine Grenzspannung von weniger als 10 Volt, weniger als 5 Volt oder weniger als 3 Volt aufweist.

2. Solarzelle (1) nach Anspruch 1, **dadurch gekennzeichnet, dass** die Antireflexionsschicht (2) einen bei 632nm Lichtwellenlänge bestimmten Brechungsindex niedriger als n=2,2, n=2,15, n=2,1, n=2,05, n=2,0, n=1,9, n=1,8, n=1,6 oder n=1,4 aufweist.

3. Solarzelle (1) nach Anspruch 1 oder 2, **dadurch gekennzeichnet, dass** die Antireflexionsschicht (2) dotiert ist.

4. Solarzelle (1) nach Anspruch 3, **dadurch gekennzeichnet, dass** die Antireflexionsschicht (2) mit Phosphor, Arsen, Fluor oder Bor dotiert ist.

5. Solarzelle (1) nach einem der vorangehenden Ansprüche, **dadurch gekennzeichnet, dass** in der Antireflexionsschicht (2) ein transparentes leitfähiges Oxid beigemischt ist.

6. Solarzelle (1) nach einem der vorangehenden Ansprüche, **dadurch gekennzeichnet, dass** die Konzentration von Störstellen in der Antireflexionsschicht (2) zur gezielten Beeinflussung der Leitfähigkeit der Antireflexionsschicht (2) eingestellt ist.

7. Solarzelle (1) nach einem der vorangehenden Ansprüche, **dadurch gekennzeichnet, dass** die Antireflexionsschicht entlang der Schichtdicke oder entlang einer Schichtoberfläche (21) der Antireflexionsschicht (2) verlaufende Leitfähigkeitskanäle (3) aufweist.

8. Solarzelle (1) nach Anspruch 5, **dadurch gekennzeichnet, dass** sich die Leitfähigkeitskanäle (3) in der Antireflexionsschicht (2) durch die gesamte Schichtdicke der Antireflexionsschicht (2) erstrecken.

9. Solarzelle (1) nach einem der vorangehenden Ansprüche, **dadurch gekennzeichnet, dass** die Antireflexionsschicht (2) aus Siliziumcarbid, Siliziumoxid, Siliziumnitrid, Siliziumoxinitrid, Aluminiumoxid, Metalloxid oder einer Kombination hieraus gebildet ist.

10. Solarzelle (1) nach einem der vorangehenden Ansprüche, **dadurch gekennzeichnet, dass** auf der Antireflexionsschicht (2) Kontaktelektroden (4) angeordnet sind.

11. Solarzellenherstellungsverfahren umfassend die folgenden Verfahrensschritte:
- Bereitstellen eines Halbleitersubstrats (10); und
- Aufbringen einer Antireflexionsschicht (2) auf eine lichteinfallseitige Vorderseitenoberfläche (11) des Halbleitersubstrats (10) derart, dass die Antireflexionsschicht (2) entlang einer Schichtdicke der Antireflexionsschicht (2) eine Grenzspannung von niedriger als 10 Volt, niedriger als 5 Volt oder niedriger als 3 Volt aufweist.

12. Prüfverfahren zum Prüfen einer Solarzelle (1) mit einer vorderseitigen Antireflexionsschicht (2) auf ihre Anfälligkeit für potentialinduzierte Degradation in einem Solarmodul, **dadurch gekennzeichnet, dass** nach einem Aufbringen der Antireflexionsschicht (2) auf eine Vorderseitenoberfläche (11) eines Halbleitersubstrats (10) der Solarzelle (1), auf der Antireflexionsschicht (2) eine Koronaentladung erzeugt wird, anschließend nach der Koronaentladung eine elektrische Oberflächenspannung der Antireflexionsschicht (2) gemessen wird und die Solarzelle (1) als anfällig für potentialinduzierte Degradation deklariert wird, wenn die gemessene elektrische Oberflächenspannung höher ist, als eine Grenzspannung von 10 Volt, 5 Volt oder 3 Volt.
